# EUROPEAN PATENT APPLICATION

(11) **EP 4 383 574 A1**
(43) Date of publication of application: **12.06.2024**
(21) Application number: 21959729.1
(22) Date of filing: 09.10.2021
(51) Int. Cl.: H03K 19/20

(54) **LOGIC GATE CIRCUIT, LATCH, AND TRIGGER**

(71) Applicant: Huawei Technologies Co., Ltd., Shenzhen, Guangdong 518129 (CN)
(72) Inventor: WU, Ying, Shenzhen, Guangdong 518129 (CN); JING, Weiliang, Shenzhen, Guangdong 518129 (CN); HOU, Zhaozhao, Shenzhen, Guangdong 518129 (CN); FAN, Renshi, Shenzhen, Guangdong 518129 (CN); XU, Jeffrey, Shenzhen, Guangdong 518129 (CN)
(74) Representative: Goddar, Heinz J.
(86) International application number: PCT/CN2021/122895
(87) International publication number: WO 2023/056639

(57) **Abstract**

This application provides a logic gate circuit, a latch, and a flip-flop, relates to the field of logic circuits, and provides a logic gate circuit that is based on an NFET. The logic gate circuit includes a pull-up network, a pull-down network, a signal output end, at least one signal input end, a first voltage end, and a second voltage end. The pull-up network includes a first NFET. The first NFET includes a first gate and a second gate. A first electrode of the first NFET and the first gate are connected to the first voltage end. A second electrode of the first NFET and the second gate are connected to the signal output end. The pull-down network includes a second NFET. The pull-down network is connected to the signal output end, the at least one signal input end, and the second voltage end. The pull-down network is configured to: control the second NFET based on a voltage of the at least one signal input end, and pull down a voltage of the signal output end by using a voltage of the second voltage end.

## Description

### TECHNICAL FIELD

This application relates to the field of logic circuits, and in particular, to a logic gate circuit, a latch, and a flip-flop.

### BACKGROUND

In a digital circuit (or a digital logic circuit), a gate is a circuit that only can implement a basic logical relationship. A most basic logical relationship is AND, OR, and NOT. A most basic logic gate circuit (or a logic gate) is an AND gate, an OR gate, and a NOT gate.

A conventional logic gate circuit is mainly manufactured based on a complementary metal-oxide-semiconductor (CMOS) technology, and in the logic gate circuit, an N-channel field-effect transistor(NFET) is used as a pull-down network (pull-down network, PDN, which may also be referred to as a pull-down network circuit). A P-channel field-effect transistor (PFET) is used as a pull-up network (PUN, which may also be referred to as a pull-up network circuit). Based on different turn-on voltages of the NFET and the PFET, the logic gate circuit may control, based on different input signals, to output different voltage signals (namely, a logical "0" signal and a logical "1" signal).

However, an application scope of the digital logic circuit manufactured by using the CMOS technology is limited by a manufacturing process condition. For example, for manufacturing of some digital logic circuits in a chip, to reduce an area of the chip and improve performance of the chip, a monolithic three-dimension integration (M3D) technology needs to be used to integrate some digital logic circuits (such as a logic unit and a storage unit) in a back-end-of-line (BEOL). However, the back-end-of-line cannot meet a high temperature (about 1000°C) requirement of the CMOS technology, in other words, the digital logic circuit using the CMOS technology cannot be integrated in the back-end-of-line.

### SUMMARY

Embodiments of this application provide a logic gate circuit, a latch, and a flip-flop, and provide a logic gate circuit based on an NFET (N-channel field-effect transistor, N-channel field-effect transistor).

This application provides a logic gate circuit, including a pull-up network, a pull-down network, a signal output end, at least one signal input end, a first voltage end, and a second voltage end. The pull-up network and the pull-down network each uses an N-channel field-effect transistor NFET. The pull-up network includes a first NFET. The first NFET includes a first gate and a second gate. A first electrode of the first NFET and the first gate are connected to the first voltage end. A second electrode of the first NFET and the second gate are connected to the signal output end. The pull-down network includes a second NFET. The pull-down network is connected to the signal output end, the at least one signal input end, and the second voltage end. The pull-down network is configured to: control the second NFET based on a voltage of the at least one signal input end, and pull down a voltage of the signal output end by using a voltage of the second voltage end.

The pull-up network and the pull-down network of the logic gate circuit provided in this embodiment of this application each uses an NFET. At least one NFET set in the pull-down network (in other words, at least the second NFET is set) can be turned on under control of a high-level voltage of the at least one signal input end, to output a low-level voltage of the second voltage end (for example, a ground end) to the signal output end, and pull down the voltage of the signal output end, implementing logical "0" signal output. The first NFET of the pull-up network is turned on under a high-level voltage of the first voltage end, to output the high-level voltage of the first voltage end to the signal output end, and pull up the voltage of the signal output end. In addition, a high-level voltage of the signal output end forms a positive feedback to the second gate of the first NFET, so that the first NFET is further turned on and a potential of the signal output end can be rapidly increased, implementing logical " 1" signal output. In other words, the logic gate circuit provided by this embodiment of this application may implement the logical "0" signal output and the logical " 1" signal output only by using the NFET.

In some possible implementations, the foregoing logic gate circuit may be a NOT gate circuit. The NOT gate circuit includes one signal input end. The second NFET includes a first gate. The signal input end is connected to the first gate of the second NFET. A first electrode of the second NFET is connected to the second voltage end. A second electrode of the second NFET is connected to the signal output end.

In some possible implementations, in the foregoing NOT gate circuit, the second NFET may further include a second gate. The second gate of the second NFET is connected to the signal input end or the second voltage end.

In some possible implementations, the logic gate circuit may be a NOR gate circuit. The NOR gate circuit includes two signal input ends. The two signal input ends are respectively a first signal input end and a second signal input end. The second NFET includes two gates. The two gates of the second NFET are respectively connected to the first signal input end and the second signal input end. A first electrode of the second NFET is connected to the second voltage end. A second electrode of the second NFET is connected to the signal output end.

In some possible implementations, the foregoing logic gate circuit may be a NOR gate circuit. The NOR gate circuit includes two signal input ends. The two signal input ends are respectively a first signal input end and a second signal input end. The pull-down network further includes a third NFET. The second NFET includes a first gate. The third NFET includes a first gate. The first signal input end is connected to the first gate of the second NFET. The second signal input end is connected to the first gate of the third NFET. A first electrode of the second NFET is connected to the second voltage end. A second electrode of the second NFET is connected to the signal output end. A first electrode of the third NFET is connected to the second voltage end. A second electrode of the third NFET is connected to the signal output end.

In some possible implementations, in the foregoing NOR gate circuit, the second NFET may further include a second gate. The second gate of the second NFET is connected to the first signal input end or the second voltage end.

In some possible implementations, in the foregoing NOR gate circuit, the third NFET may further include a second gate. The second gate of the third NFET is connected to the second signal input end or the second voltage end.

In some possible implementations, the foregoing logic gate circuit may be a NAND gate circuit. The NAND gate circuit includes two signal input ends. The two signal input ends are respectively a first signal input end and a second signal input end. The pull-down network further includes a third NFET. The second NFET includes a first gate. The third NFET includes a first gate. A first electrode of the third NFET is connected to the second voltage end. A second electrode of the third NFET is connected to the first electrode of the second NFET. A second electrode of the second NFET is connected to the signal output end. The first signal input end is connected to the first gate of the second NFET. The second signal input end is connected to the first gate of the third NFET.

In some possible implementations, in the foregoing NAND gate circuit, the second NFET may further include a second gate. The second gate of the second NFET is connected to the first signal input end; or the second gate of the second NFET is connected to the second electrode of the third NFET.

In some possible implementations, in the foregoing NAND gate circuit, the third NFET may further include a second gate. The second gate of the third NFET is connected to the second signal input end or the second voltage end.

An embodiment of this application further provides a latch, including one NOT gate circuit provided in any one of the foregoing possible implementations, and four NOR gate circuits provided in any one of the foregoing possible implementations. The four NOR gate circuits are respectively: a first NOR gate circuit, a second NOR gate circuit, a third NOR gate circuit, and a fourth NOR gate circuit. The latch includes a data input end, a first output end, a second output end, and a clock signal end. A signal input end of the NOT gate circuit and a first signal input end of the first NOR gate circuit are connected to the data input end. A signal output end of the NOT gate circuit is connected to a second signal input end of the second NOR gate circuit. A second signal input end of the first NOR gate circuit and a first signal input end of the second NOR gate circuit are connected to the clock signal end. A first signal input end of the third NOR gate circuit is connected to a signal output end of the first NOR gate circuit. A second signal input end of the fourth NOR gate circuit is connected to a signal output end of the second NOR gate circuit. Both a second signal input end of the third NOR gate circuit and a signal output end of the fourth NOR gate circuit are connected to the second output end. Both a signal output end of the third NOR gate circuit and a first signal input end of the fourth NOR gate circuit are connected to the first output end.

An embodiment of this application further provides a latch, including one NOT gate circuit provided in any one of the foregoing possible implementations, and four NAND gate circuits provided in any one of the foregoing possible implementations. The four NAND gate circuits are respectively: a first NAND gate circuit, a second NAND gate circuit, a third NAND gate circuit, and a fourth NAND gate circuit. The latch includes a data input end, a first output end, a second output end, and a clock signal end. A signal input end of the NOT gate circuit and a first signal input end of the first NAND gate circuit are connected to the data input end. A signal output end of the NOT gate circuit is connected to a second signal input end of the second NAND gate circuit. A second signal input end of the first NAND gate circuit and a first signal input end of the second NAND gate circuit are connected to the clock signal end. A first signal input end of the third NAND gate circuit is connected to a signal output end of the first NAND gate circuit. A second signal input end of the fourth NAND gate circuit is connected to a signal output end of the second NAND gate circuit. A second signal input end of the third NAND gate circuit and a signal output end of the fourth NAND gate circuit are connected to the second output end. A signal output end of the third NAND gate circuit and a first signal input end of the fourth NAND gate circuit are connected to the first output end.

An embodiment of this application further provides a flip-flop, including one NOT gate circuit provided in any one of the foregoing possible implementations, and eight NOR gate circuits provided in any one of the foregoing possible implementations. The eight NOR gate circuits are respectively: a first NOR gate circuit, a second NOR gate circuit, a third NOR gate circuit, a fourth NOR gate circuit, a fifth NOR gate circuit, a sixth NOR gate circuit, a seventh NOR gate circuit, and an eighth NOR gate circuit. The flip-flop includes a data input end, a first output end, a second output end, a first clock signal end, and a second clock signal end. Both a signal input end of the NOT gate circuit and a first signal input end of the first NOR gate circuit are connected to the data input end. A signal output end of the NOT gate circuit is connected to a second signal input end of the second NOR gate circuit. A second signal input end of the first NOR gate circuit and a first signal input end of the second NOR gate circuit are connected to the first clock signal end. A first signal input end of the third NOR gate circuit is connected to a signal output end of the first NOR gate circuit. A second signal input end of the fourth NOR gate circuit is connected to a signal output end of the second NOR gate circuit. A second signal input end of the third NOR gate circuit and a signal output end of the fourth NOR gate circuit are connected to a second signal input end of the sixth NOR gate circuit. A first signal input end of the fourth NOR gate circuit and a signal output end of the third NOR gate circuit are connected to a first signal input end of the fifth NOR gate circuit. A second signal input end of the fifth NOR gate circuit and a first signal input end of the sixth NOR gate circuit are connected to the second clock signal end. A signal output end of the fifth NOR gate circuit is connected to a first signal input end of the seventh NOR gate circuit. A signal output end of the sixth NOR gate circuit is connected to a second signal input end of the eighth NOR gate circuit. A second signal input end of the seventh NOR gate circuit and a signal output end of the eighth NOR gate circuit are connected to the second output end. A first signal input end of the eighth NOR gate circuit and a signal output end of the seventh NOR gate circuit are connected to the first output end.

An embodiment of this application further provides a flip-flop, including one NOT gate circuit provided in any one of the foregoing possible implementations, and eight NAND gate circuits provided in any one of the foregoing possible implementations. The eight NAND gate circuits are respectively: a first NAND gate circuit, a second NAND gate circuit, a third NAND gate circuit, a fourth NAND gate circuit, a fifth NAND gate circuit, a sixth NAND gate circuit, a seventh NAND gate circuit, and an eighth NAND gate circuit. The flip-flop includes a data input end, a first output end, a second output end, a first clock signal end, and a second clock signal end. A signal input end of the NOT gate circuit and a first signal input end of the first NAND gate circuit are connected to the data input end. A signal output end of the NOT gate circuit is connected to a second signal input end of the second NAND gate circuit. A second signal input end of the first NAND gate circuit and a first signal input end of the second NAND gate circuit are connected to the first clock signal end. A first signal input end of the third NAND gate circuit is connected to a signal output end of the first NAND gate circuit. A second signal input end of the fourth NAND gate circuit is connected to a signal output end of the second NAND gate circuit. A second signal input end of the third NAND gate circuit and a signal output end of the fourth NAND gate circuit are connected to a second signal input end of the sixth NAND gate circuit. A first signal input end of the fourth NAND gate circuit and a signal output end of the third NAND gate circuit are connected to a first signal input end of the fifth NAND gate circuit. A second signal input end of the fifth NAND gate circuit and a first signal input end of the sixth NAND gate circuit are connected to the second clock signal end. A signal output end of the fifth NAND gate circuit is connected to a first signal input end of the seventh NAND gate circuit. A signal output end of the sixth NAND gate circuit is connected to a second signal input end of the eighth NAND gate circuit. A second signal input end of the seventh NAND gate circuit and a signal output end of the eighth NAND gate circuit are connected to the second output end. A first signal input end of the eighth NAND gate circuit and a signal output end of the seventh NAND gate circuit are connected to the first output end.

An embodiment of this application further provides a chip, including a digital logic circuit. The digital logic circuit includes the logic gate circuit provided in any one of the foregoing possible implementations.

In some possible implementations, in the foregoing chip, the logic gate circuit may be set to be integrated in a back-end-of-line, so that a requirement of the chip on a monolithic three-dimension integration technology can be met, and objectives of reducing an area of the chip, reducing power consumption of the chip, and improving performance of the chip are achieved.

In some possible implementations, the chip further includes a substrate, a first device layer disposed on the substrate, and a second device layer. The second device layer is located on a side that is of the first device layer and that faces away from the substrate. The first device layer is electrically connected to the second device layer. A CMOS transistor is set at the first device layer. An NFET in the logic gate circuit is an oxide semiconductor field-effect transistor, and an NFET in a latch is distributed at the second device layer.

In this way, during manufacturing of the foregoing chip, the first device layer may be manufactured first by using a CMOS technology in a front-end-of-line, and then the second device layer is manufactured in a back-end-of-line. In other words, the logic gate circuit provided in this embodiment of this application is used, so that some digital logic circuits in the chip can be compatible with the back-end-of-line, and a requirement of the chip on the monolithic three-dimension integration technology can be met.

An embodiment of this application further provides an electronic device. The electronic device includes a printed circuit board and the chip provided in any one of the foregoing possible implementations. The chip is electrically connected to the printed circuit board.

### BRIEF DESCRIPTION OF DRAWINGS

FIG. 1 is a schematic diagram of a structure of a logic gate circuit according to an embodiment of this application;
FIG. 2 is a schematic diagram of a structure of a NOT gate circuit according to an embodiment of this application;
FIG. 3 is a schematic diagram of a structure of a NOT gate circuit according to an embodiment of this application;
FIG. 4 is a schematic diagram of a structure of a NOT gate circuit according to an embodiment of this application;
FIG. 5 is a schematic diagram of a structure of a NOT gate circuit according to an embodiment of this application;
FIG. 6 is a simulation diagram of a NOT gate circuit according to an embodiment of this application;
FIG. 7 is a schematic diagram of a structure of a NOR gate circuit according to an embodiment of this application;
FIG. 8 is a schematic diagram of a structure of a NOR gate circuit according to an embodiment of this application;
FIG. 9 is a simulation diagram of a NOR gate circuit according to an embodiment of this application;
FIG. 10 is a schematic diagram of a structure of a NAND gate circuit according to an embodiment of this application;
FIG. 11 is a simulation diagram of a NAND gate circuit according to an embodiment of this application;
FIG. 12 is a schematic diagram of a structure of a latch according to an embodiment of this application;
FIG. 13 is a simulation diagram of a latch according to an embodiment of this application;
FIG. 14 is a schematic diagram of a structure of a latch according to an embodiment of this application;
FIG. 15 is a simulation diagram of a latch according to an embodiment of this application;
FIG. 16 is a schematic diagram of a structure of a flip-flop according to an embodiment of this application;
FIG. 17 is a simulation diagram of a flip-flop according to an embodiment of this application;
FIG. 18 is a schematic diagram of a structure of a flip-flop according to an embodiment of this application;
FIG. 19 is a simulation diagram of a flip-flop according to an embodiment of this application; and
FIG. 20 is a schematic diagram of a structure of a chip according to an embodiment of this application.

### DESCRIPTION OF EMBODIMENTS

To make the objectives, technical solutions, and advantages of this application clearer, the following clearly describes the technical solutions in this application with reference to the accompanying drawings in this application. It is clear that the described embodiments are merely some rather than all of embodiments of this application. All other embodiments obtained by a person of ordinary skill in the art based on embodiments of this application without creative efforts shall fall within the protection scope of this application.

The terms "first", "second", and the like in embodiments of the specification in this application, claims, and accompanying drawings are merely used for distinguishing and description, but should not be understood as indicating or implying relative importance, or should not be understood as indicating or implying a sequence. A similar term such as "connected" or "connection" is used to express interconnection or interaction between different components, including direct connection or indirection connection between another component. In addition, the terms "include" and "have" and any variation thereof are intended to cover a non-exclusive inclusion, for example, a method, system, product, or device that includes a series of steps or units, which is not necessarily limited to those clearly listed steps or units, but may include other steps or units that are not clearly listed or inherent to the process, method, product, or device. "Up", "down", "left", and "right" are only used relative to a direction of a component in the accompanying drawings. These directional terms are opposite concepts. They are used for relative description and clarification, and may change correspondingly based on a change of the direction in which the component in the accompanying drawings is placed.

It should be understood that in this application, "at least one (item)" means one or more and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between associated objects. "At least one of the following items (pieces)" or a similar expression thereof indicates any combination of these items, including a single item (piece) or any combination of a plurality of items (pieces). For example, at least one of a, b, or c may indicate a, b, or c, "a and b", "a and c", "b and c", or "a, b, and c", where a, b, and c may be singular or plural.

Compared with a conventional technology in which an application scope of a digital logic circuit is limited because the digital logic circuit is manufactured based on a CMOS technology, embodiments of this application provide a logic gate circuit based on an NFET. Manufacturing of the logic gate circuit is not limited to the CMOS technology, so that an application scope of the digital logic circuit can be further expanded.

For example, in some possible implementations, the NFET used in the logic gate circuit provided in embodiments of this application may be an N-channel oxide semiconductor (OS) field-effect transistor, in other words, a channel layer of the NFET uses an oxide semiconductor material.

A person skilled in the art may understand that a manufacturing temperature of the N-channel oxide semiconductor field-effect transistor is relatively low, so that an application of the digital logic circuit in a low-temperature manufacturing condition can be met.

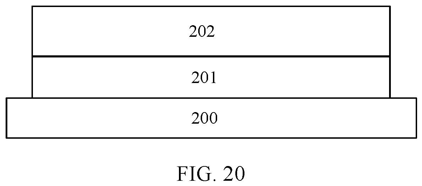

An application of the digital logic circuit in a chip is used as an example. Based on that the logic gate circuit provided in embodiments of this application may use an N-channel oxide semiconductor field-effect transistor, some digital logic circuits (such as a logic unit and a storage unit) in the chip can be integrated with a back-end-of-line (BEOL) of the chip (for details, refer to the following and FIG. 20), so that an area of the chip can be reduced, power consumption of the chip can be reduced, and performance of the chip can be improved.

Certainly, according to an actual requirement, in some possible implementations, the NFET in the logic gate circuit provided in embodiments of this application may also use another manufacturing technology, for example, a low-temperature polycrystalline silicon (LTPS) technology, in other words, a channel layer of the NFET uses a polycrystalline silicon material. This is not limited in this application. The following embodiments are described by using an example in which the NFET is the N-channel oxide semiconductor field-effect transistor.

The following specifically describes the logic gate circuit provided in embodiments of this application.

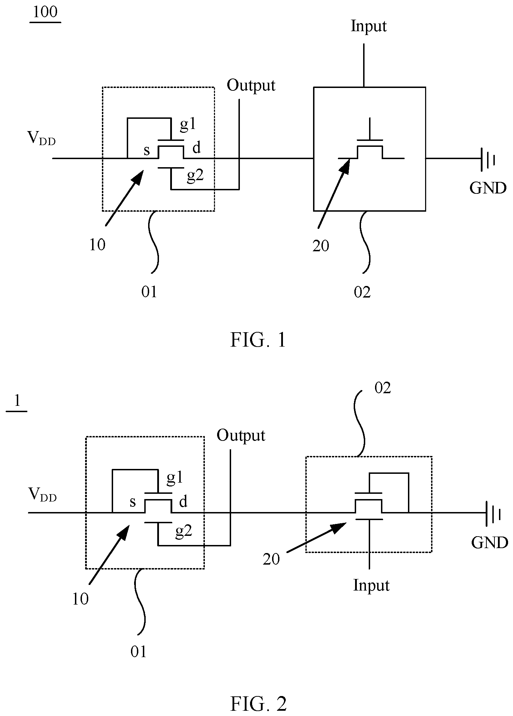

As shown in FIG. 1, a logic gate circuit 100 provided in this embodiment of this application includes a pull-up network 01, a pull-down network 02, a signal output end Output, at least one signal input end Input, a first voltage end, and a second voltage end. The pull-up network 01 and the pull-down network 02 each uses an NFET. The first voltage end may be a high-level voltage end, for example, a power supply end V_{DD}. The second voltage end may be a low-level voltage end, for example, a ground end GND. This is not limited herein.

The pull-up network 01 includes a first NFET 10, and the first NFET 10 may also be referred to as a load transistor. The first NFET 10 includes a first gate g1, a second gate g2, a source s, and a drain d. The source s and the first gate g 1 of the first NFET 10 are connected to the first voltage end (V_{DD}), and the drain d and the second gate g2 of the first NFET 10 are both connected to the signal output end Output.

It may be understood that the foregoing first NFET 10 is of a dual-gate structure and has two gates (the first gate and the second gate). One of the first gate g1 and the second gate g2 is a top gate, and the other is a back gate. FIG. 1 is described only by using an example in which the second gate g2 is the top gate and the first gate g2 is the back gate. The following is described by using an example in which the first gate is the top gate and the second gate is the back gate.

In addition, in the NFET in this application, two electrodes (a first electrode and a second electrode) other than the gates are respectively the source s and the drain d, and the source s and the drain d may be equivalently interchanged. In other words, if the first electrode is the source s, the second electrode is the drain d. If the first electrode is the drain d, the second electrode is the source s. The following embodiments of this application are described by using an example in which the first electrode is the source s and the second electrode is the drain d.

For the foregoing pull-up network 01, the first NFET 10 is turned on under control of a high-level voltage of the first voltage end (V_{DD}), to output the high-level voltage of the first voltage end (V_{DD}) to the signal output end Output. In addition, a high-level voltage of the signal output end Output forms a positive feedback to the second gate g2 of the first NFET 10, so that the first NFET 10 is further turned on and a potential of the signal output end Output can be rapidly increased.

In addition, refer to FIG. 1. In the logic gate circuit 100, the pull-down network 02 includes at least a second NFET, in other words, the pull-down network 02 includes at least one NFET. The NFET in the pull-down network 02 may also be referred to as a drive transistor. The pull-down network 02 is connected to the at least one signal input end Input, the second voltage end (GND), and the signal output end Output. The pull-down network 02 is configured to: control a second NFET 20 based on a voltage of the signal input end Input, and pull down a voltage of the signal output end Output by using a voltage of the second voltage end (GND). In other words, under control of a high-level voltage of the at least one signal input end Input, the second NFET 20 in the pull-down network 02 can output a low-level voltage of the second voltage end (GND) to the signal output end Output.

It may be understood that, in addition to the second NFET 20, another NFET may also be set in the pull-down network 02. A quantity of NFETs in the pull-down network 02 and a quantity of signal input ends Input connected to the pull-down network 02 are determined based on a logical relationship actually implemented by the logic gate circuit.

For example, in some possible implementations, when the logic gate circuit 100 implements a NOT gate (inverter) logical relationship, one NFET (the second NFET) may be set in the pull-down network 02, and the pull-down network 02 may be connected to one signal input end Input. For a specific circuit setting, refer to the following related descriptions.

For another example, in some possible implementations, when the logic gate circuit 100 implements a NOR (not-or gate, NOR) gate logical relationship, two NFETs (the second NFET and a third NFET) or one NFET (the second NFET) may be set in the pull-down network 02, and the pull-down network 02 may be connected to two signal input ends. For a specific circuit setting, refer to the following related descriptions.

For still another example, in some possible implementations, when the logic gate circuit 100 implements a NAND gate (not-and gate) logical relationship, two NFETs (the second NFET and a third NFET) may be set in the pull-down network 02, and the pull-down network 02 may be connected to two signal input ends. For a specific circuit setting, refer to the following related descriptions.

In conclusion, in the logic gate circuit 100 provided in this embodiment of this application, the pull-up network 01 and the pull-down network 02 each uses the NFET. The at least one NFET set in the pull-down network 02 (in other words, at least the second NFET is set) can be turned on under control of the high-level voltage of the at least one signal input end Input, to output the low-level voltage of the second voltage end (GND) to the signal output end Output, and pull down the voltage of the signal output end, thereby implementing logical "0" signal output. The first NFET 10 in the pull-up network 01 is turned on under control of the high-level voltage of the first voltage end (V_{DD}), to output the high-level voltage of the first voltage end (V_{DD}) to the signal output end Output, and pull up the voltage of the signal output end. In addition, the high-level voltage of the signal output end Output forms the positive feedback to the second gate g2 of the first NFET 10, so that the first NFET 10 is further turned on and the potential of the signal output end Output can be rapidly increased, thereby implementing logical "1" signal output. In other words, the logic gate circuit 100 provided in this embodiment of this application may implement the logical "0" signal output and the logic " 1" signal output only by using the NFET.

The logic gate circuit 100 provided in this embodiment of this application may be set to keep the pull-up network 01 unchanged (to be specific, the first NFET 10 is used), and only adjust a setting of the pull-down network 02, to implement the logic gate circuit 100 (for example, a NOT gate circuit, a NOR gate circuit, or a NAND gate circuit) with different logical relationships. The following describes a specific setting of the pull-down network 02 through specific embodiments when the logic gate circuit 100 is a NOT gate circuit, a NOR gate circuit, or a NAND gate circuit.

### Embodiment 1

Refer to FIG. 2, FIG. 3, FIG. 4, and FIG. 5. In Embodiment 1, a logic gate circuit 100 is a NOT gate circuit 1. In this case, a pull-down network 02 includes one NFET (namely, the second NFET 20), and the pull-down network 02 is connected to a signal input end Input.

For example, as shown in FIG. 2, in some possible implementations, the second NFET 20 may be of a dual-gate structure. A back gate of the second NFET 20 is connected to the signal input end Input. Both a top gate and a source of the second NFET 20 are connected to the second voltage end (GND). A drain of the second NFET 20 is connected to a signal output end Output.

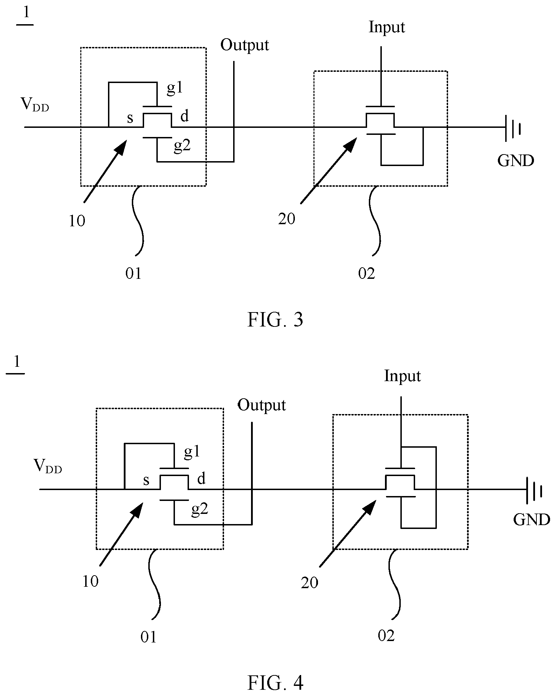

For example, as shown in FIG. 3, in some possible implementations, the second NFET 20 may be of a dual-gate structure. A top gate of the second NFET 20 is connected to the signal input end Input. Both a back gate and a source of the second NFET 20 are connected to a second voltage end (GND). A drain of the second NFET 20 is connected to a signal output end Output.

For example, as shown in FIG. 4, in some possible implementations, the second NFET 20 may be of a dual-gate structure. Both a top gate and a back gate of the second NFET 20 are connected to the signal input end Input. A source of the second NFET 20 is connected to a second voltage end (GND). A drain of the second NFET 20 is connected to a signal output end Output.

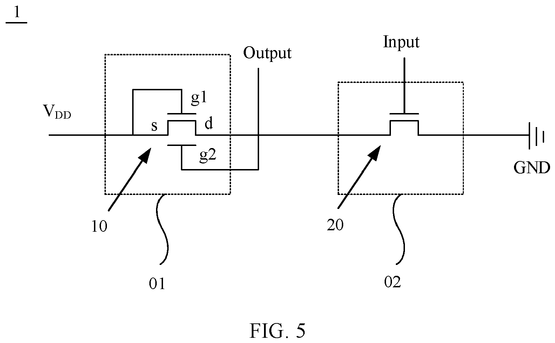

For example, as shown in FIG. 5, in some possible implementations, the second NFET 20 may be of a single-gate structure. A gate of the second NFET 20 is connected to the signal input end Input. A source of the second NFET 20 is connected to a second voltage end (GND). A drain of the second NFET 20 is connected to a signal output end Output.

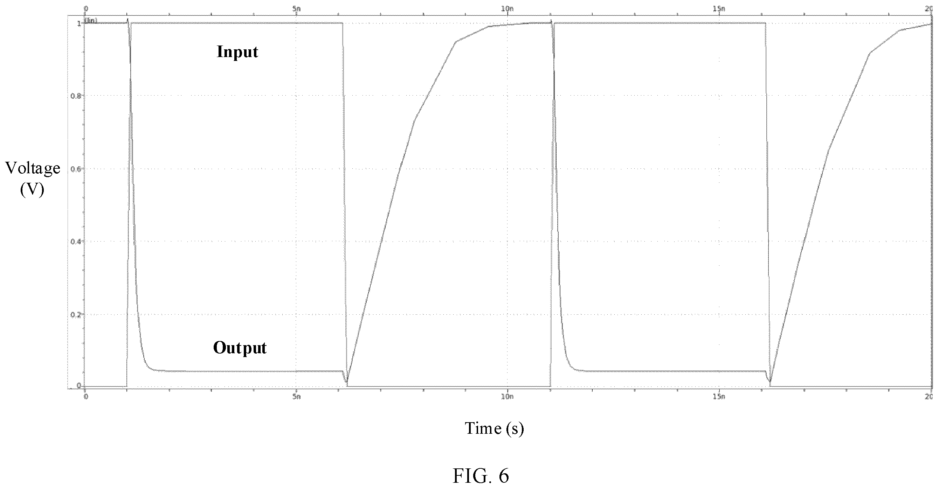

FIG. 6 is a simulation diagram of the NOT gate circuit 1 shown in FIG. 2. The following briefly describes a working principle of the NOT gate circuit 1 with reference to FIG. 6 and FIG. 2.

Refer to FIG. 2 and FIG. 6. The second NFET 20 is turned on when a voltage of a signal input to the signal input end Input is a high-level voltage. In this case, resistance of the second NFET 20 is far less than resistance of a first NFET 10, so that a low-level voltage of the second voltage end (GND) is output to the signal output end Output, and a voltage of the signal output end Output is pulled down. In other words, when the high-level voltage is input to the signal input end Input, the signal output end Output outputs a low-level voltage (namely, a logical "0" signal). The second NFET 20 is turned off when a voltage of a signal input to the signal input end Input is a low-level voltage. The first NFET 10 is turned on under control of a high-level voltage of a first voltage end (V_{DD}). In this case, resistance of the first NFET 10 is far less than resistance of the second NFET 20, so that the high-level voltage of the first voltage end (V_{DD}) is output to the signal output end Output, and a voltage of the signal output end Output is pulled up. In addition, a high-level voltage of the signal output end Output forms a positive feedback to a second gate g2 of the first NFET 10, so that the first NFET 10 is further turned on and a potential of the signal output end Output can be rapidly increased. In other words, when the low-level voltage is input to the signal input end Input, the signal output end Output outputs the high-level voltage (namely, a logical "1" signal).

In addition, it can be learned from FIG. 6 that the NOT gate circuit 1 in this embodiment of this application can implement inverted output close to full swing.

### Embodiment 2

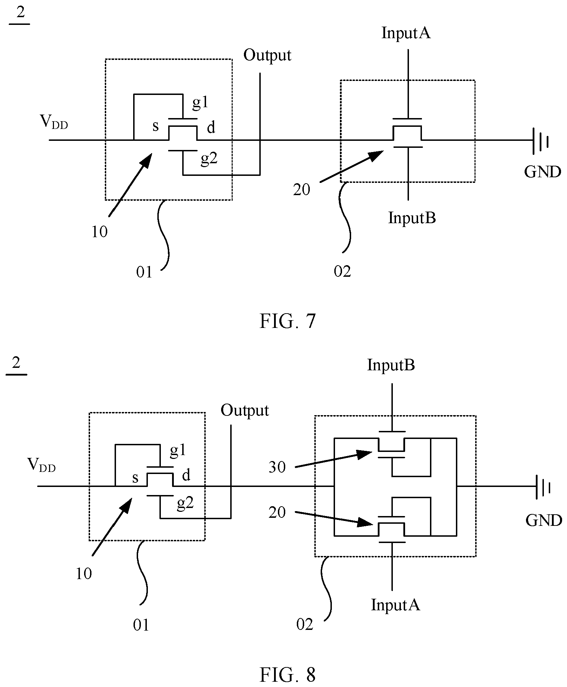

Refer to FIG. 7. In Embodiment 2, a logic gate circuit 100 is a NOR gate circuit 2. In this case, a pull-down network 02 is connected to two signal input ends (a first signal input end InputA and a second signal input end InputB). In the NOR gate circuit 2, as shown in FIG. 7, one NFET (namely, a second NFET 20) may be set in the pull-down network 02. As shown in FIG. 8, two NFETs (a second NFET 20 and a third NFET 30) may alternatively be set in the pull-down network 02.

For example, as shown in FIG. 7, in some possible implementations, the second NFET 20 may be of a dual-gate structure. A source of the second NFET 20 is connected to a second voltage end (GND). A drain of the second NFET 20 is connected to a signal output end Output. One of two gates of the second NFET 20 is connected to the first signal input end InputA, and the other is connected to the second signal input end InputB. For example, in some embodiments, a top gate of the second NFET 20 may be connected to the first signal input end InputA. A back gate of the second NFET 20 may be connected to the second signal input end InputB (as shown in FIG. 7). For another example, in some embodiments, a top gate of the second NFET 20 may be connected to the second signal input end InputB. A back gate of the second NFET 20 may be connected to the first signal input end InputA.

For example, as shown in FIG. 8, in some possible implementations, the two NFETs (the second NFET 20 and the third NFET 30) may be set in the pull-down network 02. The second NFET 20 and the third NFET 30 are set in parallel between a second voltage end (GND) and a signal output end Output. In other words, a source of the second NFET 20 is connected to the second voltage end (GND). A drain of the second NFET 20 is connected to the signal output end Output. A source of the third NFET 30 is connected to the second voltage end (GND). A drain of the third NFET 30 is connected to the signal output end Output.

A gate setting manner of the foregoing second NFET 20 and the third NFET 30 may be similar to a setting of the second NFET 20 in Embodiment 1. The second NFET 20 and the third NFET 30 may be of dual-gate structures, or may be of single-gate structures. A specific connection manner may be as follows:

For example, in some possible implementations, when the second NFET 20 and the third NFET 30 are of the dual-gate structures, as shown in FIG. 8, a back gate of the second NFET 20 is connected to the first signal input end InputA. Atop gate of the second NFET 20 is connected to the second voltage end (GND). A back gate of the third NFET 30 is connected to the second signal input end InputB. A top gate of the third NFET 30 is connected to the second voltage end (GND).

For another example, in some other possible implementations, a connection relationship between a top gate and a back gate of the second NFET 20 or the third NFET 30 in FIG. 8 may be exchanged (refer to a gate setting manner of the second NFET 20 in FIG. 3). To be specific, a top gate of the second NFET 20 is connected to the first signal input end InputA. A back gate of the second NFET 20 is connected to the second voltage end (GND). A top gate of the third NFET 30 is connected to the second signal input end InputB. A back gate of the third NFET 30 is connected to the second voltage end (GND).

For still another example, in some possible implementations, when the second NFET 20 and the third NFET 30 are of the dual-gate structures, refer to a gate setting manner of the second NFET 20 in FIG. 4. In the NOR gate circuit 2, it may be set that both a top gate and a back gate of the second NFET 20 are connected to the first signal input end InputA, and both a top gate and a back gate of the third NFET 30 are connected to the second signal input end InputB.

For still another example, in some possible implementations, when the second NFET 20 and the third NFET 30 are of the single-gate structures, refer to a gate setting manner of the second NFET 20 in FIG. 5. In the NOR gate circuit 2, it may be set that the first signal input end InputA is connected to a gate of the second NFET 20, and the second signal input end InputB is connected to a gate of the third NFET 30.

Certainly, the foregoing descriptions are provided by using an example in which the second NFET 20 and the third NFET 30 both are of the dual-gate structures or the single-gate structures, and both are connected in a same connection manner. However, this is not limited in this application. In some embodiments, the second NFET 20 and the third NFET 30 in the NOR gate circuit 2 may also have different setting structures, for example, one may be of the dual-gate structure, and the other may be of the single-gate structure. For details about the connection manner, refer to the foregoing descriptions. Details are not described herein again.

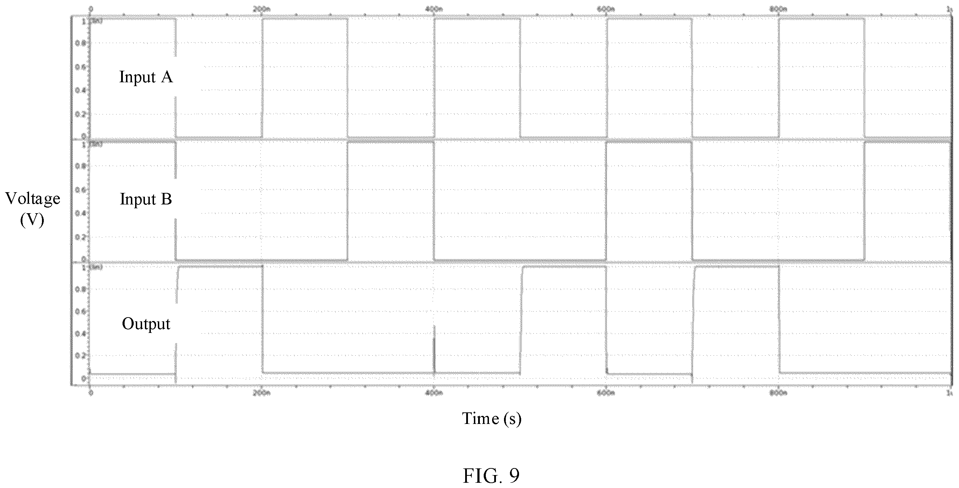

FIG. 9 is a simulation diagram of the NOR gate circuit 2 shown in FIG. 7. The following briefly describes a working principle of the NOR gate circuit 2 with reference to FIG. 9 and FIG. 7.

Refer to FIG. 7 and FIG. 9. The second NFET 20 is turned off when both the first signal input end InputA and the second signal input end InputB are of low-level voltages. A first NFET 10 is turned on under control of a high-level voltage of a first voltage end (V_{DD}). In this case, resistance of a first NFET 10 is far less than resistance of the second NFET 20, so that the high-level voltage of the first voltage end (V_{DD}) is output to the signal output end Output, and a voltage of the signal output end Output is pulled up. In addition, a high-level voltage of the signal output end Output forms a positive feedback to a second gate g2 of the first NFET 10, so that the first NFET 10 is further turned on and a potential of the signal output end Output can be rapidly increased. In other words, when the low-level voltages are input to both the first signal input end InputA and the second signal input end InputB, the signal output end Output outputs the high-level voltage (namely, a logical " 1" signal). The second NFET 20 is turned on when a high-level voltage is input to at least one of the first signal input end InputA and the second signal input end InputB. In this case, resistance of the second NFET 20 is far less than resistance of a first NFET 10, so that a low-level voltage of the second voltage end (GND) is output to the signal output end Output, and a voltage of the signal output end Output is pulled down. In other words, when the high-level voltage is input to the at least one of the first signal input end InputA and the second signal input end InputB, the signal output end Output outputs a low-level voltage (namely, a logical "0" signal).

Compared with a NOR gate circuit that uses a CMOS technology and requires four transistors, the NOR gate circuit provided in Embodiment 2 only needs two NFETs or three NFETs to implement a logical function of the NOR gate circuit, that is, the NOR gate circuit provided in Embodiment 2 can reduce a quantity of transistors, thereby reducing an area of a device (for example, a chip).

### Embodiment 3

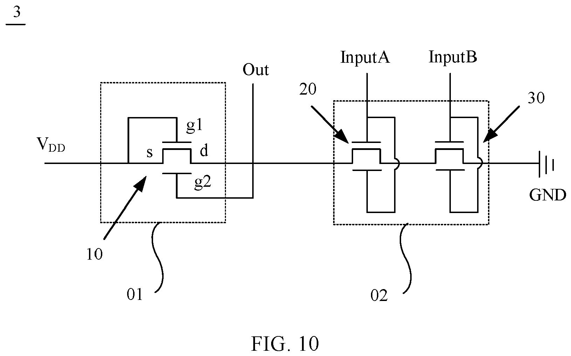

Refer to FIG. 10. In Embodiment 3, a logic gate circuit 100 is a NAND gate circuit 3. In this case, a pull-down network 02 is connected to two signal input ends (a first signal input end InputA and a second signal input end InputB). Two NFETs (a second NFET 20 and a third NFET 30) are set in the pull-down network 02. A source of the third NFET 30 is connected to a second voltage end (GND). A drain of the third NFET 30 is connected to a source of the second NFET 20. A drain of the second NFET 20 is connected to a signal output end Output. In other words, the second NFET 20 and the third NFET 30 are set in series between the second voltage end (GND) and the signal output end Output.

A gate setting manner and a connection manner of the foregoing second NFET 20 and the third NFET 30 may be similar to a setting of the second NFET 20 in Embodiment 1. In the NAND gate circuit 3, the second NFET 20 and the third NFET 30 may be of dual-gate structures, or may be of single-gate structures. A specific connection manner may be as follows:

For example, in some possible implementations, as shown in FIG. 10, in the NAND gate circuit 3, the second NFET 20 and the third NFET 30 may be of the dual-gate structures. Both a top gate and a back gate of the second NFET 20 are connected to the first signal input end InputA, and both a top gate and a back gate of the third NFET 30 are connected to the second signal input end InputB.

For another example, in some possible implementations, refer to a gate setting manner of the second NFET 20 in FIG. 2. In the NAND gate circuit 3, the second NFET 20 and the third NFET 30 may be of the dual-gate structures. A back gate of the second NFET 20 is connected to the first signal input end InputA. A top gate of the second NFET 20 is connected to the drain of the third NFET 30. A back gate of the third NFET 30 is connected to the second signal input end InputB. Both a top gate and the source of the third NFET 30 are connected to the second voltage end (GND).

For still another example, in other possible implementations, refer to a gate setting manner of the second NFET 20 in FIG. 3. In the NAND gate circuit 3, the second NFET 20 and the third NFET 30 are of the dual-gate structures. A top gate of the second NFET 20 is connected to the first signal input end InputA. A back gate of the second NFET 20 is connected to the drain of the third NFET 30. A top gate of the third NFET 30 is connected to the second signal input end InputB. Both a back gate and the source of the third NFET 30 are connected to the second voltage end (GND).

For still another example, in some possible implementations, refer to a gate setting manner of the second NFET 20 in FIG. 5. In the NAND gate circuit 3, the second NFET 20 and the third NFET 30 may be of the single-gate structures. The first signal input end InputA is connected to a gate of the second NFET 20, and the second signal input end InputB is connected to a gate of the third NFET 30.

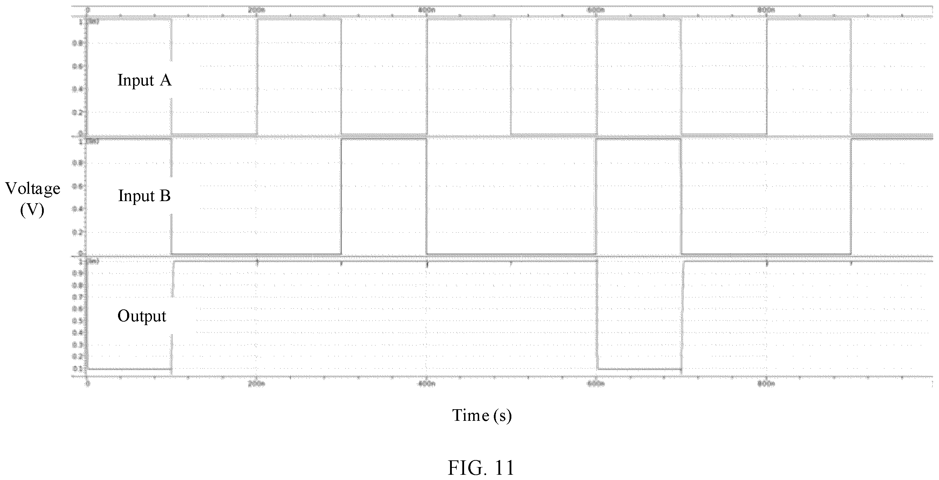

FIG. 11 is a simulation diagram of the NAND gate circuit 3 shown in FIG. 10. The following briefly describes a working principle of the NAND gate circuit 3 with reference to FIG. 11 and FIG. 10.

Refer to FIG. 10 and FIG. 11. The second NFET 20 and the third NFET 30 are turned on when both the first signal input end InputA and the second signal input end InputB are of high-level voltages. In this case, resistance of the pull-down network is far less than resistance of a pull-up network, so that a low-level voltage of the second voltage end (GND) is output to the signal output end Output, and a voltage of the signal output end Output is pulled down. In other words, when the high-level voltages are input to both the first signal input end InputA and the second signal input end InputB, the signal output end Output outputs a low-level voltage (namely, a logical "0" signal). At least one of the second NFET 20 and the third NFET 30 is turned off when a low-level voltage is input to at least one of the first signal input end InputA and the second signal input end InputB. A first NFET 10 is turned on under control of a high-level voltage of a first voltage end (V_{DD}). In this case, resistance of a pull-up network is far less than resistance of the pull-down network, so that the high-level voltage of the first voltage end (V_{DD}) is output to the signal output end Output, and a voltage of the signal output end Output is pulled up. In addition, a high-level voltage of the signal output end Output forms a positive feedback to a second gate g2 of the first NFET 10, so that the first NFET 10 is further turned on and a potential of the signal output end Output can be rapidly increased. In other words, when the low-level voltage is input to the at least one of the first signal input end InputA and the second signal input end InputB, the signal output end Output outputs the high-level voltage (namely, a logical "1" signal).

In addition, based on the NOT gate circuit 1, the NOR gate circuit 2, and the NAND gate circuit 3 provided in the foregoing embodiments, a logic function circuit (or a device) in a digital logic circuit may be further formed, such as a latch or a flip-flop. However, this is not limited in this application.

For example, based on the NOT gate circuit 1, the NOR gate circuit 2, and the NAND gate circuit 3 provided in the foregoing embodiments, an embodiment of this application provides two different latches (latch) and two different flip-flops (FFs). The following separately describes specific circuit settings of two different latches (a latch 1 and a latch 2) and two different flip-flops (a flip-flop 1 and a flip-flop 2).

### Latch 1

Based on the NOT gate circuit 1 provided in the foregoing Embodiment 1 and the NOR gate circuit 2 provided in Embodiment 2, this application provides the latch 1.

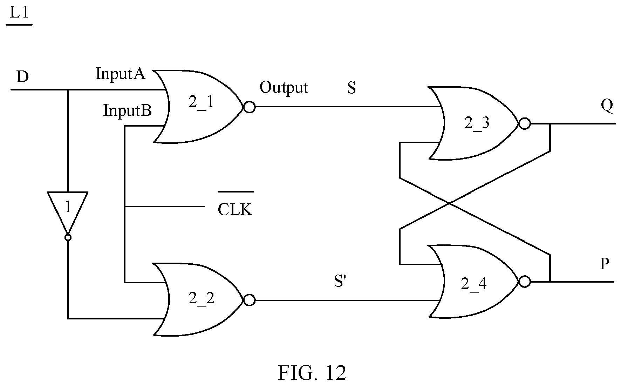

As shown in FIG. 12, a latch 1-L1 may include one NOT gate circuit 1 and four NOR gate circuits 2. The four NOR gate circuits 2 are respectively: a first NOR gate circuit 2_1, a second NOR gate circuit 2_2, a third NOR gate circuit 2_3, and a fourth NOR gate circuit 2_4. Specific circuits of the four NOR gate circuits (2_1, 2_2, 2_3, and 2_4) may be completely the same, or may be not completely the same. This is not limited in this application.

The following describes a specific connection manner of the NOT gate circuit 1 and the four NOR gate circuits (2_1, 2_2, 2_3, and 2_4) in the latch 1-L1.

As shown in FIG. 12, the latch 1-L1 includes a data input end D, a first output end Q, a second output end P, and a clock signal end C̅L̅K̅. A signal input end of the NOT gate circuit 1 and a first signal input end InputA of the first NOR gate circuit 2_1 are connected to the data input end D. A signal output end of the NOT gate circuit 1 is connected to a second signal input end InputB of the second NOR gate circuit 2_2. A second signal input end InputB of the first NOR gate circuit 2_1 and a first signal input end InputA of the second NOR gate circuit 2_2 are connected to the clock signal end C̅L̅K̅. A first signal input end InputA of the third NOR gate circuit 2_3 is connected to a signal output end of the first NOR gate circuit 2_1. Both a second signal input end InputB of the third NOR gate circuit 2_3 and a signal output end of the fourth NOR gate circuit 2_4 are connected to the second output end P. Both a signal output end of the third NOR gate circuit 2_3 and a first signal input end InputA of the fourth NOR gate circuit 2_4 are connected to the first output end Q. A second signal input end InputB of the fourth NOR gate circuit 2_4 is connected to a signal output end of the second NOR gate circuit 2_2.

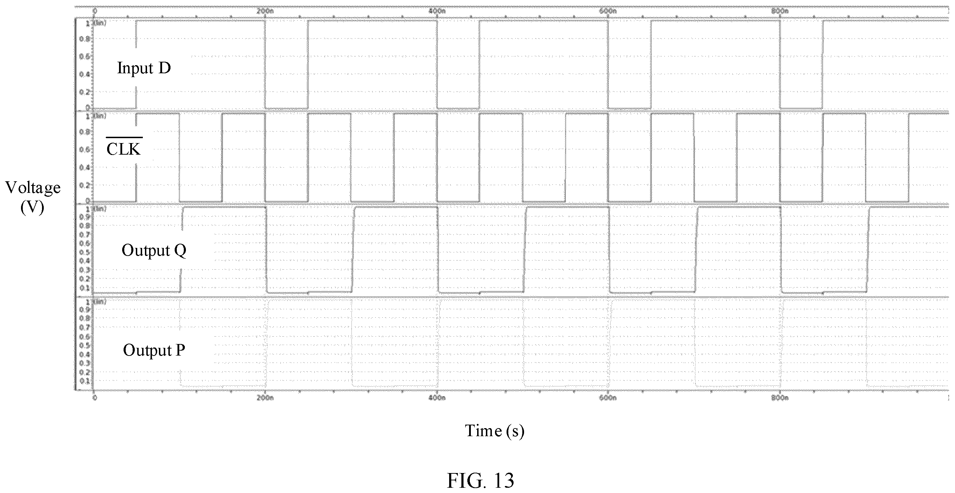

For example, the NOT gate circuit 1 in the latch 1-L 1 uses a NOT gate circuit structure shown in FIG. 2, and all the four NOR gate circuits (2_1, 2_2, 2_3, and 2_4) use a NOR gate circuit structure shown in FIG. 7. FIG. 13 is a simulation diagram of the latch 1-L1, and a truth table 1 is a truth table of the latch 1-L1. Potentials of S and S' in the truth table 1 respectively correspond to potentials of an S end and an S' end in FIG. 12. A CLK signal in the truth table 1 is an inverted signal of an input signal of the clock signal end C̅L̅K̅.

Refer to FIG. 12, FIG. 13, and the truth table 1. It can be learned that, only when a CLK signal is a high-level potential (in other words, CLK = 1, and C̅L̅K̅ = 0), an input signal (corresponding to InputD in FIG. 13) of the data input end D can be transmitted to the first output end Q (corresponding to OutputQ in FIG. 13) by using the latch 1-L1. When a CLK signal is a low-level potential (in other words, CLK = 0, and C̅L̅K̅ = 1), the latch 1-L1 maintains an original state (namely, PRE). An input signal of the data input end D cannot change output of the first output end Q. An output signal (corresponding to OutputP in FIG. 13) of the second output end P and an output signal of the first output end Q are a group of inverted signals.

**Truth table 1**

| | CLK=1 | | CLK=0 | |
|---|---|---|---|---|
| | D=0 | D=1 | D=0 | D=1 |
| S | 1 | 0 | 0 | 0 |
| S' | 0 | 1 | 0 | 0 |
| P | 1 | 0 | PRE | PRE |
| Q | 0 | 1 | PRE | PRE |

### Latch 2

Based on the NOT gate circuit 1 provided in the foregoing Embodiment 1 and the NAND gate circuit 3 provided in Embodiment 3, this application further provides the latch 2.

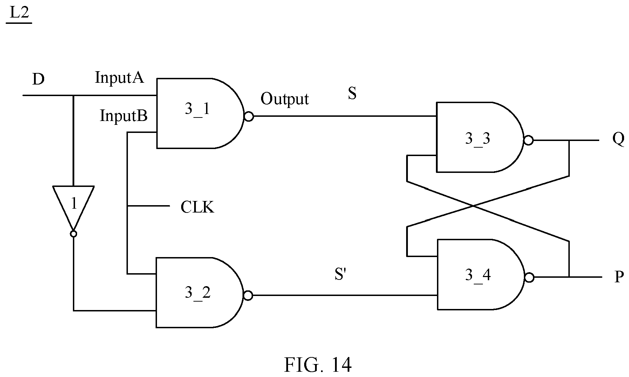

As shown in FIG. 14, a latch 2-L2 may include one NOT gate circuit 1 and four NAND gate circuits 3. The four NAND gate circuits 3 are respectively: a first NAND gate circuit 3_1, a second NAND gate circuit 3_2, a third NAND gate circuit 3_3, and a fourth NAND gate circuit 3_4. Specific circuits of the four NAND gate circuits (3_1, 3_2, 3_3, and 3_4) may be completely the same, or may be not completely the same. This is not limited in this application.

The following describes a specific connection manner of the NOT gate circuit 1 and the four NAND gate circuits (3_1, 3_2, 3_3, and 3_4) in the latch 2-L2.

As shown in FIG. 14, the latch 2-L2 includes a data input end D, a first output end Q, a second output end P, and a clock signal end CLK. Both a signal input end of the NOT gate circuit 1 and a first signal input end InputA of the first NAND gate circuit 3_1 are connected to the data input end D. A signal output end of the NOT gate circuit 1 is connected to a second signal input end InputB of the second NAND gate circuit 3_2. Both a second signal input end InputB of the first NAND gate circuit 3_1 and a first signal input end InputA of the second NAND gate circuit 3_2 are connected to the clock signal end CLK. A first signal input end InputA of the third NAND gate circuit 3_3 is connected to a signal output end of the first NAND gate circuit 3_1. Both a second signal input end InputB of the third NAND gate circuit 3_3 and a signal output end of the fourth NAND gate circuit 3_4 are connected to the second output end P. Both a signal output end of the third NAND gate circuit 3_3 and a first signal input end InputA of the fourth NAND gate circuit 3_4 are connected to the first output end Q. A second signal input end InputB of the fourth NAND gate circuit 3_4 is connected to a signal output end of the second NAND gate circuit 3_2.

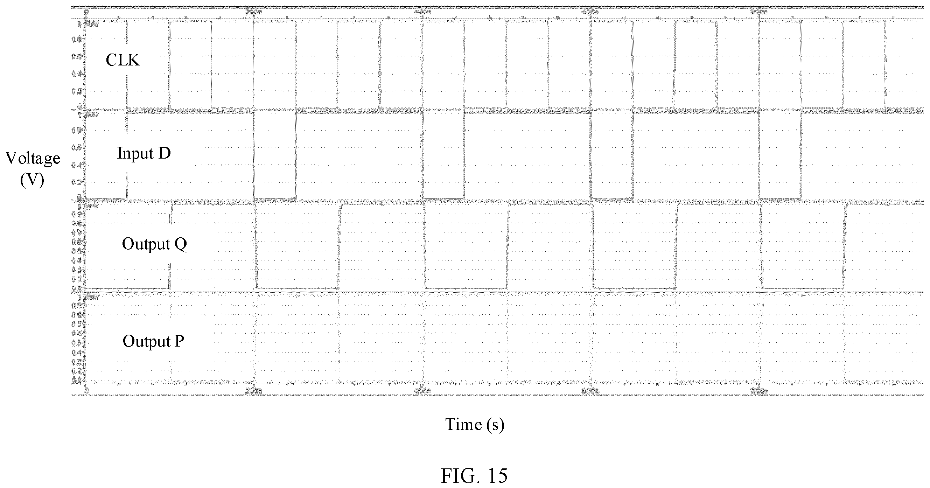

For example, the NOT gate circuit 1 in the latch 2-L2 uses a NOT gate circuit structure shown in FIG. 2, and all the four NAND gate circuits (3_1, 3_2, 3_3, and 3_4) use a NAND gate circuit structure shown in FIG. 10. FIG. 15 is a simulation diagram of the latch 2-L2, and a truth table 2 is a truth table of the latch 2-L2. Potentials of S and S' in the truth table 2 respectively correspond to potentials of an S end and an S' end in FIG. 14.

**Truth table 2**

| | CLK=1 | | CLK=0 | |
|---|---|---|---|---|
| | D=0 | D=1 | D=0 | D=1 |
| S | 1 | 0 | 1 | 1 |
| S' | 0 | 1 | 1 | 1 |
| P | 1 | 0 | PRE | PRE |
| Q | 0 | 1 | PRE | PRE |

Refer to FIG. 14, FIG. 15, and the truth table 2. It can be learned that, only when a clock signal input to the clock signal end CLK is a high-level potential (in other words, CLK=1), an input signal (corresponding to InputD in FIG. 15) of the data input end D can be output to the first output end Q (corresponding to OutputQ in FIG. 15) by using the latch 2-L2. When a clock signal input to the clock signal end CLK is a low-level potential (in other words, CLK=0), the latch 2-L2 maintains an original state (namely, PRE), and an input signal of the data input end D cannot change output of the first output end Q. An output signal (corresponding to OutputP in FIG. 13) of the second output end P and an output signal of the first output end Q are a group of inverted signals.

### Flip-flop 1

Based on the NOT gate circuit 1 provided in the foregoing Embodiment 1 and the NOR gate circuit 2 provided in Embodiment 2. This application provides the flip-flop 1.

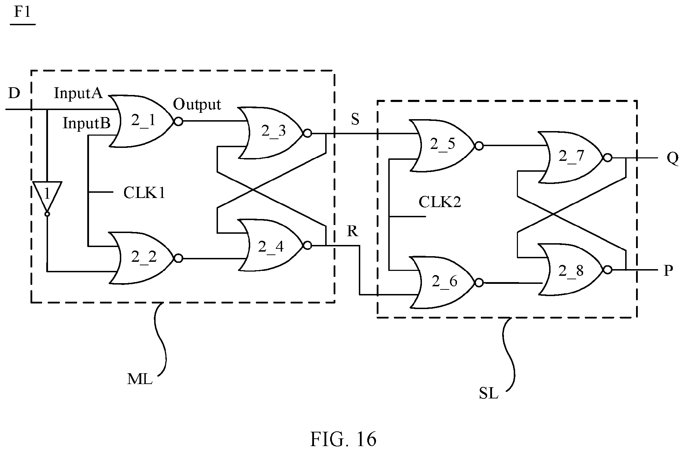

As shown in FIG. 16, a flip-flop 1-F1 may include one NOT gate circuit 1 and eight NOR gate circuits 2. The eight NOR gate circuits 2 are respectively: a first NOR gate circuit 2_1, a second NOR gate circuit 2_2, a third NOR gate circuit 2_3, a fourth NOR gate circuit 2_4, a fifth NOR gate circuit 2_5, a sixth NOR gate circuit 2_6, a seventh NOR gate circuit 2_7, and an eighth NOR gate circuit 2_8. Specific circuits of the eight NOR gate circuits (2_1, 2_2, 2_3, 2_4, 2_5, 2_6, 2_7, and 2_8) may be completely the same, or may be not completely the same. This is not limited in this application.

The following describes a specific connection manner of the NOT gate circuit 1 and the eight NOR gate circuits (2_1, 2_2, 2_3, 2_4, 2_5, 2_6, 2_7, and 2_8) in the flip-flop 1-F1.

As shown in FIG. 16, the flip-flop 1-F 1 includes a data input end D, a first output end Q, a second output end P, a first clock signal end CLK1, and a second clock signal end CLK2. Both a signal input end of the NOT gate circuit 1 and a first signal input end InputA of the first NOR gate circuit 2_1 are connected to the data input end D. A signal output end of the NOT gate circuit 1 is connected to a second signal input end InputB of the second NOR gate circuit 2_2. Both a second signal input end InputB of the first NOR gate circuit 2_1 and a first signal input end InputA of the second NOR gate circuit 2_2 are connected to the first clock signal end CLK1. A first signal input end InputA of the third NOR gate circuit 2_3 is connected to a signal output end of the first NOR gate circuit 2_1. A second signal input end InputB of the fourth NOR gate circuit 2_4 is connected to a signal output end of the second NOR gate circuit 2_2. Both a second signal input end InputB of the third NOR gate circuit 2_3 and a signal output end of the fourth NOR gate circuit 2_4 are connected to a second signal input end InputB of the sixth NOR gate circuit 2_6. Both a first signal input end InputA of the fourth NOR gate circuit 2_4 and a signal output end of the third NOR gate circuit 2_3 are connected to a first signal input end InputA of the fifth NOR gate circuit 2_5. Both a second signal input end InputB of the fifth NOR gate circuit 2_5 and a first signal input end InputA of the sixth NOR gate circuit 2_6 are connected to the second clock signal end CLK2. A signal output end of the fifth NOR gate circuit 2_5 is connected to a first signal input end InputA of the seventh NOR gate circuit 2_7. A signal output end of the sixth NOR gate circuit 2_6 is connected to a second signal input end InputB of the eighth NOR gate circuit 2_8. Both a second signal input end InputB of the seventh NOR gate circuit 2_7 and a signal output end of the eighth NOR gate circuit 2_8 are connected to the second output end P. A first signal input end InputA of the eighth NOR gate circuit 2_8 and a signal output end of the seventh NOR gate circuit 2_7 are connected to the first output end Q.

Refer to FIG. 16. In the flip-flop 1-F 1, the NOT gate circuit 1, the first NOR gate circuit 2_1, the second NOR gate circuit 2_2, the third NOR gate circuit 2_3, and the fourth NOR gate circuit 2_4 form a master latch ML (master latch), and the fifth NOR gate circuit 2_5, the sixth NOR gate circuit 2_6, the seventh NOR gate circuit 2_7, and the eighth NOR gate circuit 2_8 form a slave latch SL (slave latch).

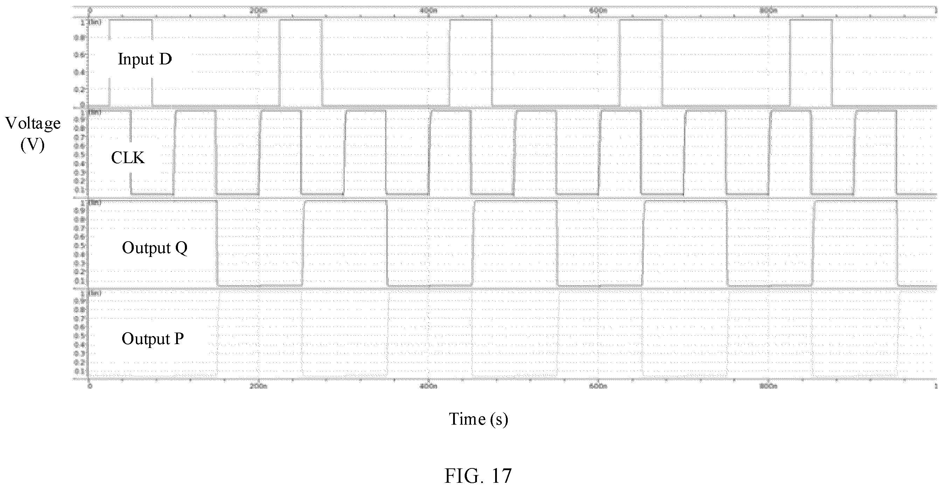

For example, the NOT gate circuit 1 in the flip-flop 1-F1 uses a NOT gate circuit structure shown in FIG. 2, and all the eight NOR gate circuits use a NOR gate circuit structure shown in FIG. 7. FIG. 17 is a simulation diagram of the flip-flop 1-F1. Clock signals received by the first clock signal end CLK1 and the second clock signal end CLK2 are a group of inverted clock signals. A CLK signal in FIG. 17 may be correspondingly input to the second clock signal end CLK2, and an inverted signal (namely, a C̅L̅K̅ signal) of the CLK signal may be input to the first clock signal end CLK1. For example, an inverter (for example, the NOT gate circuit in the foregoing Embodiment 1) may be used to perform inversion on the CLK signal to obtain the C̅L̅K̅ signal.

Refer to FIG. 16 and FIG. 17. It can be learned that, when a clock signal input to the second clock signal end CLK2 is a high-level potential (in other words, CLK = 1, and C̅L̅K̅ = 0), an input signal (corresponding to InputD in FIG. 17) of the data input end D is transmitted to an S end by using the master latch ML. However, because CLK=1, in this case, an output state of the slave latch SL is irrelevant to output of the S end, and is in a hold state. When a clock signal input to the second clock signal end CLK2 is a low-level potential (in other words, CLK = 0, and C̅L̅K̅ = 1), in this case, a signal transmitted to an S end by the master latch ML is irrelevant to an input signal of the data input end D, and output of the S end remains unchanged and is output to the first output end Q (corresponding to OutputQ in FIG. 17) by using the slave latch SL. In this case, only when the clock signal input to the second clock signal end CLK2 changes from the high potential to the low potential (namely, a negative CLK edge, in other words, a negative edge of the clock signal), the input signal of the data input end D can be output to the first output end Q, in other words, the flip-flop implements a negative-edge-triggered FF (namely, a negative-edge-triggered FF). An output signal (corresponding to OutputP in FIG. 17) of the second output end P and an output signal of the first output end Q are a group of inverted signals.

Certainly, in some other possible implementations, the clock signals input to the first clock signal end CLK1 and the second clock signal end CLK2 may be interchanged, to be specific, the CLK signal in FIG. 17 is input to the first clock signal end CLK1, and the inverted signal (namely, the C̅L̅K̅ signal) of the CLK signal in FIG. 17 is input to the second clock signal end CLK2. In this case, the flip-flop can implement a positive-edge-triggered FF (namely, a positive-edge-triggered FF). In other words, the input signal of the data input end D can be output to the first output end Q only when the clock signal changes from the low potential to the high potential.

In other words, the foregoing flip-flop 1-F1 may implement the negative-edge-triggered FF, or may implement the positive-edge-triggered FF.

### Flip-flop 2

Based on the NOT gate circuit 1 provided in the foregoing Embodiment 1 and the NAND gate circuit 3 provided in Embodiment 3. This application provides the flip-flop 2.

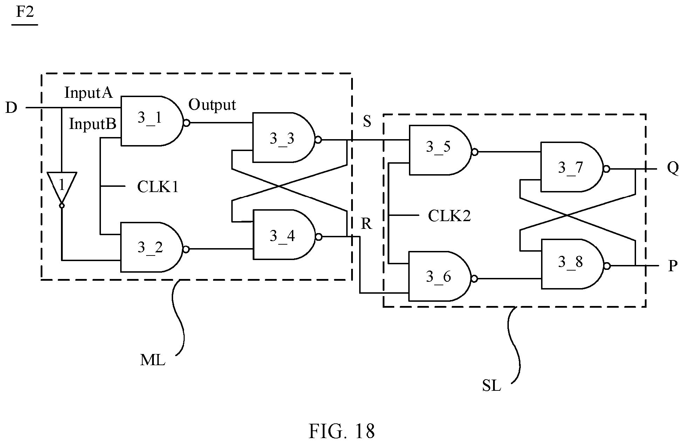

As shown in FIG. 18, a flip-flop 2-F2 may include one NOT gate circuit 1 and eight NAND gate circuits 3. The eight NAND gate circuits 3 are respectively: a first NAND gate circuit 3_1, a second NAND gate circuit 3_2, a third NAND gate circuit 3_3, a fourth NAND gate circuit 3_4, a fifth NAND gate circuit 3_5, a sixth NAND gate circuit 3_6, a seventh NAND gate circuit 3_7, and an eighth NAND gate circuit 3_8. The eight NAND gate circuits (3_1, 3_2, 3_3, 3_4, 3_5, 3_6, 3_7, and 3_8) may be completely the same, or may be not completely the same. This is not limited in this application.

The following describes a specific connection manner of the NOT gate circuit 1 in the flip-flop 2-F2 and the eight NAND gate circuits (3_1, 3_2, 3_3, 3_4, 3_5, 3_6, 3_7, and 3_8).

As shown in FIG. 18, the flip-flop 2-F2 includes a data input end D, a first output end P, a second output end Q, a first clock signal end CLK1, and a second clock signal end CLK2. Both a signal input end of the NOT gate circuit 1 and a first signal input end InputA of the first NAND gate circuit 3_1 are connected to the data input end D. A signal output end of the NOT gate circuit 1 is connected to a second signal input end InputB of the second NAND gate circuit 3_1. Both a second signal input end InputB of the first NAND gate circuit 3_1 and a first signal input end InputA of the second NAND gate circuit 3_2 are connected to the first clock signal end CLK 1. A first signal input end InputA of the third NAND gate circuit 3_3 is connected to a signal output end Output of the first NAND gate circuit 3_1. A second signal input end InputB of the fourth NAND gate circuit 3_4 is connected to a signal output end of the second NAND gate circuit 3_2. Both a second signal input end InputB of the third NAND gate circuit 3_3 and a signal output end of the fourth NAND gate circuit 3_4 are connected to a second signal input end InputB of the sixth NAND gate circuit 3_6. A first signal input end InputA of the fourth NAND gate circuit 3_4 and a signal output end of the third NAND gate circuit 3_3 are connected to a first signal input end InputA of the fifth NAND gate circuit 3_5. Both a second signal input end InputB of the fifth NAND gate circuit 3_5 and a first signal input end InputA of the sixth NAND gate circuit 3_6 are connected to the second clock signal end CLK2. A signal output end of the fifth NAND gate circuit 3_5 is connected to a first signal input end InputA of the seventh NAND gate circuit 3_7. A signal output end of the sixth NAND gate circuit 3_6 is connected to a second signal input end InputB of the eighth NAND gate circuit 3_8. Both a second signal input end InputB of the seventh NAND gate circuit 3_7 and a signal output end of the eighth NAND gate circuit 3_8 are connected to the second output end P. Both a first signal input end InputA of the eighth NAND gate circuit 3_8 and a signal output end of the seventh NAND gate circuit 3_7 are connected to the first output end Q.

Refer to FIG. 18. In the flip-flop 2-F2, the NOT gate circuit 1, the first NAND gate circuit 3_1, the second NAND gate circuit 3_2, the third NAND gate circuit 3_3, and the fourth NAND gate circuit 3_4 form a master latch ML (master latch), and the fifth NAND gate circuit 3_5, the sixth NAND gate circuit 3_6, the seventh NAND gate circuit 3_7, and the eighth NAND gate circuit 3_8 form a slave latch SL (slave latch).

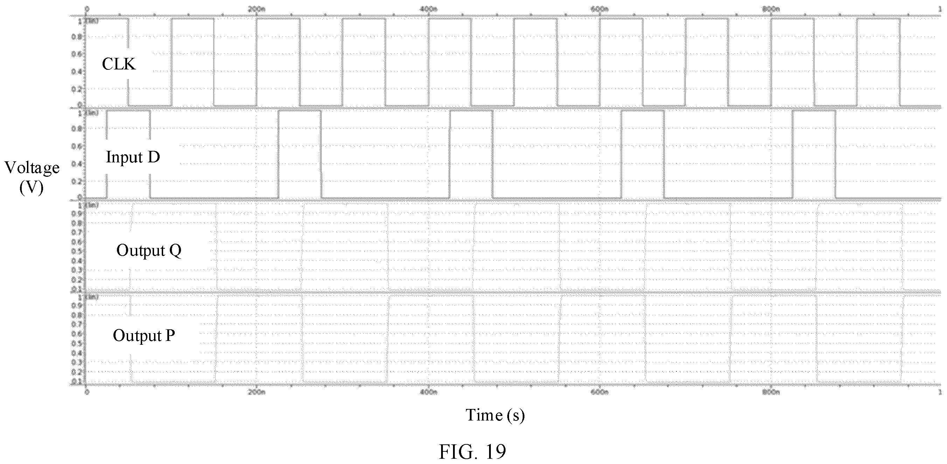

For example, the NOT gate circuit 1 in the flip-flop 2-F2 uses a NOT gate circuit structure shown in FIG. 2, and all the eight NAND gate circuits use a NAND gate circuit structure shown in FIG. 10. FIG. 19 is a simulation diagram of the flip-flop 2-F2. Clock signals received by the first clock signal end CLK1 and the second clock signal end CLK2 are a group of inverted clock signals. The CLK signal in FIG. 19 is correspondingly input to the first clock signal end CLK1, and an inverted signal (namely, a C̅L̅K̅ signal) of the CLK signal is input to the second clock signal end CLK2. For example, an inverter (for example, the NOT gate circuit in the foregoing Embodiment 1) may be used to perform inversion on the CLK signal to obtain the C̅L̅K̅ signal.

Refer to FIG. 18 and FIG. 19. When a clock signal input to the first clock signal end CLK1 is a high-level potential (in other words, CLK = 1, and C̅L̅K̅ = 0), an input signal (corresponding to InputD in FIG. 19) of the data input end D is transmitted to an S end by using the master latch ML. However, because CLK = 1, in this case, an output state of the slave latch SL is irrelevant to output of the S end, and is in a hold state. When a clock signal input to the first clock signal end CLK1 is a low-level potential (in other words, CLK = 0, and C̅L̅K̅ = 1), in this case, a signal transmitted to an S end by the master latch ML is irrelevant to an input signal of the data input end D, and output of the S end remains unchanged and is output to the first output end Q (corresponding to OutputQ in FIG. 19) by using the slave latch SL. Therefore, only when the clock signal input to the first clock signal end CLK1 is converted from the high potential to the low potential (namely, a negative CLK edge, in other words, a negative edge of the clock signal), the input signal of the data input end D can be output to the first output end Q, that is, the flip-flop implements a negative-edge-triggered FF (namely, a negative-edge-triggered FF). An output signal (corresponding to OutputP in FIG. 19) of the second output end P and an output signal of the first output end Q are a group of inverted signals.

Certainly, in some other possible implementations, the clock signals input to the first clock signal end CLK1 and the second clock signal end CLK2 may be interchanged, to be specific, the CLK signal in FIG. 19 is input to the second clock signal end CLK2, and the inverted signal (namely, the C̅L̅K̅ signal) of the CLK signal in FIG. 19 is input to the first clock signal end CLK1. In this case, the flip-flop can implement a positive-edge-triggered FF (namely, a positive-edge-triggered FF). In other words, the input signal of the data input end D can be output to the first output end Q only when the clock signal is converted from the low potential to the high potential.

In other words, the foregoing flip-flop 2-F2 may implement the negative-edge-triggered FF, or may implement the positive-edge-triggered FF.

In addition, an embodiment of this application further provides a digital logic circuit. The digital logic circuit may include the logic gate circuit provided in any one of the foregoing possible implementations. For example, the digital logic circuit may include one or more of the NOT gate circuit, the NOR gate circuit, and the NAND gate circuit provided in the foregoing embodiments.

An embodiment of this application further provides a chip. A digital logic circuit in the chip may include the foregoing logic gate circuit (such as the flip-flop or the latch).

In some possible implementations, the logic gate circuit may be set to be integrated in a back-end-of-line of the chip, so that a requirement of the chip on a monolithic three-dimension integration technology can be met, and objectives of reducing an area of the chip, reducing power consumption of the chip, and improving performance of the chip are achieved.

For example, in some possible implementations, as shown in FIG. 20, the chip provided in this embodiment of this application may include a substrate 200, a first device layer 201 disposed on the substrate 200, and a second device layer 202. The second device layer 202 is located on a side that is of the first device layer 201 and that is away from the substrate 200. The first device layer 201 is electrically connected to the second device layer 202. For example, the first device layer 201 and the second device layer 202 may be electrically connected through a metal micro through hole.

A complementary metal-oxide-semiconductor field-effect transistor (CMOS transistor) is set at the first device layer 201, and the foregoing logic gate circuit based on the NFET is set at the second device layer 202. For example, in some possible implementations, the NFET in the logic gate circuit is an N-channel oxide semiconductor (OS) field-effect transistor, in other words, a channel layer of the NFET uses an oxide semiconductor material. In some possible implementations, the NFET in the logic gate circuit may be manufactured by using a low-temperature polycrystalline silicon (LTPS) technology, in other words, the channel layer of the NFET uses a polycrystalline silicon material. This is not limited in this application, and may be set according to a requirement in practice. Certainly, it may be understood that, compared with the LTPS technology, the use of an N-channel oxide semiconductor (OS) field-effect transistor has advantages of a simple process and a low cost.

In this way, during manufacturing of the foregoing chip, the first device layer 201 may be manufactured first in a front-end-of-line (front-end-of-line,FEOL) by using a CMOS technology, and then the second device layer 202 is manufactured in a back-end-of-line (BEOL). In other words, the logic gate circuit provided in this embodiment of this application is used, so that some digital logic circuits in the chip can be compatible with the back-end-of-line, and a requirement of the chip on the monolithic three-dimension integration technology can be met.

For example, in some digital logic chips, the flip-flop occupies about 40% of an area of the digital logic chip. Therefore, the flip-flop is set in the second device layer 202 in a setting manner of this application, so that an area of the chip can be greatly reduced.

In addition, an embodiment of this application further provides an electronic device. The electronic device includes a printed circuit board (PCB) and the foregoing chip. The chip is electrically connected to the PCB.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A logic gate circuit, comprising a pull-up network, a pull-down network, a signal output end, at least one signal input end, a first voltage end, and a second voltage end, wherein
the pull-up network and the pull-down network each use an N-channel field-effect transistor (NFET);
the pull-up network comprises a first NFET, the first NFET comprises a first gate and a second gate, a first electrode of the first NFET and the first gate are connected to the first voltage end, and a second electrode of the first NFET and the second gate are connected to the signal output end;
the pull-down network comprises a second NFET, the pull-down network is connected to the signal output end, the at least one signal input end, and the second voltage end; and
the pull-down network is configured to: control the second NFET based on a voltage of the at least one signal input end, and pull down a voltage of the signal output end by using a voltage of the second voltage end.

2. The logic gate circuit according to claim 1, wherein
the logic gate circuit is a NOT gate circuit, and the NOT gate circuit comprises one signal input end;
the second NFET comprises a first gate;
the signal input end is connected to the first gate of the second NFET; and
a first electrode of the second NFET is connected to the second voltage end, and a second electrode of the second NFET is connected to the signal output end.

3. The logic gate circuit according to claim 2, wherein
the second NFET further comprises a second gate; and
the second gate of the second NFET is connected to the signal input end or the second voltage end.

4. The logic gate circuit according to claim 1, wherein
the logic gate circuit is a NOR gate circuit;
the NOR gate circuit comprises two signal input ends, and the two signal input ends are respectively a first signal input end and a second signal input end;
the second NFET comprises two gates, and the two gates of the second NFET are respectively connected to the first signal input end and the second signal input end; and
a first electrode of the second NFET is connected to the second voltage end, and a second electrode of the second NFET is connected to the signal output end.

5. The logic gate circuit according to claim 1, wherein
the logic gate circuit is a NOR gate circuit, the NOR gate circuit comprises two signal input ends, and the two signal input ends are respectively a first signal input end and a second signal input end;
the pull-down network further comprises a third NFET, the second NFET comprises a first gate, and the third NFET comprises a first gate;
the first signal input end is connected to the first gate of the second NFET, and the second signal input end is connected to the first gate of the third NFET;
a first electrode of the second NFET is connected to the second voltage end, and a second electrode of the second NFET is connected to the signal output end; and
a first electrode of the third NFET is connected to the second voltage end, and a second electrode of the third NFET is connected to the signal output end.

6. The logic gate circuit according to claim 5, wherein
the second NFET further comprises a second gate; and
the second gate of the second NFET is connected to the first signal input end or the second voltage end.

7. The logic gate circuit according to claim 5 or 6, wherein
the third NFET further comprises a second gate; and
the second gate of the third NFET is connected to the second signal input end or the second voltage end.

8. The logic gate circuit according to claim 1, wherein
the logic gate circuit is a NAND gate circuit, the NAND gate circuit comprises two signal input ends, and the two signal input ends are respectively a first signal input end and a second signal input end;
the pull-down network further comprises a third NFET, the second NFET comprises a first gate, and the third NFET comprises a first gate;
a first electrode of the third NFET is connected to the second voltage end, a second electrode of the third NFET is connected to a first electrode of the second NFET, and a second electrode of the second NFET is connected to the signal output end; and
the first signal input end is connected to the first gate of the second NFET, and the second signal input end is connected to the first gate of the third NFET.

9. The logic gate circuit according to claim 8, wherein
the second NFET further comprises a second gate; and
the second gate of the second NFET is connected to the first signal input end; or the second gate of the second NFET is connected to the second electrode of the third NFET.

10. The logic gate circuit according to claim 8 or 9, wherein
the third NFET further comprises a second gate; and
the second gate of the third NFET is connected to the second signal input end or the second voltage end.

11. A latch, comprising one NOT gate circuit according to claim 2 or 3 and four NOR gate circuits according to any one of claims 4 to 7, wherein
the four NOR gate circuits are respectively: a first NOR gate circuit, a second NOR gate circuit, a third NOR gate circuit, and a fourth NOR gate circuit;
the latch comprises a data input end, a first output end, a second output end, and a clock signal end;
a signal input end of the NOT gate circuit and a first signal input end of the first NOR gate circuit are connected to the data input end; and a signal output end of the NOT gate circuit is connected to a second signal input end of the second NOR gate circuit;
a second signal input end of the first NOR gate circuit and a first signal input end of the second NOR gate circuit are connected to the clock signal end; and
a first signal input end of the third NOR gate circuit is connected to a signal output end of the first NOR gate circuit; a second signal input end of the fourth NOR gate circuit is connected to a signal output end of the second NOR gate circuit; both a second signal input end of the third NOR gate circuit and a signal output end of the fourth NOR gate circuit are connected to the second output end; and both a signal output end of the third NOR gate circuit and a first signal input end of the fourth NOR gate circuit are connected to the first output end.

12. A latch, comprising one NOT gate circuit according to claim 2 or 3 and four NAND gate circuits according to any one of claims 8 to 10, wherein
the four NAND gate circuits are respectively: a first NAND gate circuit, a second NAND gate circuit, a third NAND gate circuit, and a fourth NAND gate circuit;
the latch comprises a data input end, a first output end, a second output end, and a clock signal end;
both a signal input end of the NOT gate circuit and a first signal input end of the first NAND gate circuit are connected to the data input end; and a signal output end of the NOT gate circuit is connected to a second signal input end of the second NAND gate circuit;
a second signal input end of the first NAND gate circuit and a first signal input end of the second NAND gate circuit are connected to the clock signal end; and
a first signal input end of the third NAND gate circuit is connected to a signal output end of the first NAND gate circuit; a second signal input end of the fourth NAND gate circuit is connected to a signal output end of the second NAND gate circuit; both a second signal input end of the third NAND gate circuit and a signal output end of the fourth NAND gate circuit are connected to the second output end; and both a signal output end of the third NAND gate circuit and a first signal input end of the fourth NAND gate circuit are connected to the first output end.

13. A flip-flop, comprising one NOT gate circuit according to claim 2 or 3 and eight NOR gate circuits according to any one of claims 4 to 7, wherein
the eight NOR gate circuits are respectively: a first NOR gate circuit, a second NOR gate circuit, a third NOR gate circuit, a fourth NOR gate circuit, a fifth NOR gate circuit, a sixth NOR gate circuit, a seventh NOR gate circuit, and an eighth NOR gate circuit;
the flip-flop comprises a data input end, a first output end, a second output end, a first clock signal end, and a second clock signal end;
both a signal input end of the NOT gate circuit and a first signal input end of the first NOR gate circuit are connected to the data input end; and a signal output end of the NOT gate circuit is connected to a second signal input end of the second NOR gate circuit;
a second signal input end of the first NOR gate circuit and a first signal input end of the second NOR gate circuit are connected to the first clock signal end;
a first signal input end of the third NOR gate circuit is connected to a signal output end of the first NOR gate circuit;
a second signal input end of the fourth NOR gate circuit is connected to a signal output end of the second NOR gate circuit;
a second signal input end of the third NOR gate circuit and a signal output end of the fourth NOR gate circuit are connected to a second signal input end of the sixth NOR gate circuit;
a first signal input end of the fourth NOR gate circuit and a signal output end of the third NOR gate circuit are connected to a first signal input end of the fifth NOR gate circuit;
a second signal input end of the fifth NOR gate circuit and a first signal input end of the sixth NOR gate circuit are connected to the second clock signal end;
a signal output end of the fifth NOR gate circuit is connected to a first signal input end of the seventh NOR gate circuit;
a signal output end of the sixth NOR gate circuit is connected to a second signal input end of the eighth NOR gate circuit;
both a second signal input end of the seventh NOR gate circuit and a signal output end of the eighth NOR gate circuit are connected to the second output end; and
both a first signal input end of the eighth NOR gate circuit and a signal output end of the seventh NOR gate circuit are connected to the first output end.

14. A flip-flop, comprising one NOT gate circuit according to claim 2 or 3 and eight NAND gate circuits according to any one of claims 8 to 10, wherein
the eight NAND gate circuits are respectively: a first NAND gate circuit, a second NAND gate circuit, a third NAND gate circuit, a fourth NAND gate circuit, a fifth NAND gate circuit, a sixth NAND gate circuit, a seventh NAND gate circuit, and an eighth NAND gate circuit;
the flip-flop comprises a data input end, a first output end, a second output end, a first clock signal end, and a second clock signal end;
a signal input end of the NOT gate circuit and a first signal input end of the first NAND gate circuit are connected to the data input end; and a signal output end of the NOT gate circuit is connected to a second signal input end of the second NAND gate circuit;
a second signal input end of the first NAND gate circuit and a first signal input end of the second NAND gate circuit are connected to the first clock signal end;
a first signal input end of the third NAND gate circuit is connected to a signal output end of the first NAND gate circuit;
a second signal input end of the fourth NAND gate circuit is connected to a signal output end of the second NAND gate circuit;
a second signal input end of the third NAND gate circuit and a signal output end of the fourth NAND gate circuit are connected to a second signal input end of the sixth NAND gate circuit;
a first signal input end of the fourth NAND gate circuit and a signal output end of the third NAND gate circuit are connected to a first signal input end of the fifth NAND gate circuit;
a second signal input end of the fifth NAND gate circuit and a first signal input end of the sixth NAND gate circuit are connected to the second clock signal end;
a signal output end of the fifth NAND gate circuit is connected to a first signal input end of the seventh NAND gate circuit;
a signal output end of the sixth NAND gate circuit is connected to a second signal input end of the eighth NAND gate circuit;
both a second signal input end of the seventh NAND gate circuit and a signal output end of the eighth NAND gate circuit are connected to the second output end; and
both a first signal input end of the eighth NAND gate circuit and a signal output end of the seventh NAND gate circuit are connected to the first output end.

15. A chip, comprising a digital logic circuit, wherein
the digital logic circuit comprises the logic gate circuit according to any one of claims 1 to 10.

16. The chip according to claim 15, wherein the logic gate circuit is integrated in a back-end-of-line.

17. An electronic device, comprising a printed circuit board and the chip according to claim 15 or 16, wherein the chip is electrically connected to the printed circuit board.
